(19) **Europäisches Patentamt**
**European Patent Office**
**Office européen des brevets**

(11) **EP 2 632 047 B1**

(12) **EUROPÄISCHE PATENTSCHRIFT**

(45) Veröffentlichungstag und Bekanntmachung des Hinweises auf die Patenterteilung:
**02.07.2014 Patentblatt 2014/27**

(51) Int Cl.:
*H03K 17/08* (2006.01)       *H03K 19/003* (2006.01)

(21) Anmeldenummer: **12156353.0**

(22) Anmeldetag: **21.02.2012**

(54) **Schutzschaltung und Automatisierungskomponente**

Protective switch and automation components

Circuit protecteur et composants d'automatisation

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.08.2013 Patentblatt 2013/35**

(73) Patentinhaber: **Siemens Aktiengesellschaft 80333 München (DE)**

(72) Erfinder: **Nötzold, Thomas 09337 Bernsdorf (DE)**

(56) Entgegenhaltungen:
**WO-A1-94/29961        WO-A1-2010/038107 US-A1- 2008 084 642**

**Beschreibung**

Die Erfindung betrifft eine Schutzschaltung zum Schutz eines Eingangs oder eines Ausgangs einer elektrischen Vorrichtung vor einer Überspannung.

Des Weiteren betrifft die Erfindung eine Automatisierungskomponente mit einer elektrischen Vorrichtung zum Automatisieren industrieller Prozesse, welcher einen Ein- oder Ausgangskanal umfasst.

Schutzschaltungen zum Schutz vor elektrischen Schaltungsteilen einer elektrischen Vorrichtung sind bereits z.B. aus der Patentschrift WO 94/29961 bekannt. Eine der häufigsten derzeit bekannten Schutzschaltungen besteht aus zwei Dioden, welche zum Einen mit dem Eingang gegen ein positives Potential und zum Anderen mit dem Eingang gegen ein negatives Potential verbunden sind. Diese Schaltung ist dem Fachmann als eine "Clamping" Diodenschaltung bekannt, sie dient der Begrenzung auf eine positive und auf eine negative Spannung. Hierzu liegen eine erste Diode mit ihrer Anode an dem zu schützenden Eingang und eine zweite Diode mit ihrer Katode an dem zu schützenden Eingang. Des Weiteren liegt ein Widerstand in Serie mit dem zu schützenden Eingang.

Bei dieser Schutzschaltung ist es von Nachteil, dass der im Signalweg des Einganges eingebrachte Serienwiderstand in der Regel hochohmig ist, welches sich ungünstig auf über den Eingang zu erfassende Signalströme auswirkt.

Es ist die Aufgabe der vorliegenden Erfindung eine Schutzschaltung bereitzustellen, welche auf einen hochohmigen Serienwiderstand im Signalweg verzichten kann.

Bei einer Schutzschaltung zum Schutz eines Einganges oder eines Ausganges einer elektrischen Vorrichtung vor einer Überspannung wird die Aufgabe dadurch gelöst, dass an dem Eingang oder dem Ausgang eine Reihenschaltung angeordnet ist, wobei die Reihenschaltung einen ersten Transistor und einen zweiten Transistor umfasst, der erste Transistor ist als ein n-Kanal Feldeffekttransistor und der zweite Transistor ist als ein p-Kanal Feldeffekttransistor ausgestaltet, wobei jeder der Transistoren einen Gate-Anschluss, einen Drain-Anschluss und einen Source-Anschluss aufweist, wobei der Drain-Anschluss des ersten Transistors an einer ersten Anschlussstelle und der Source-Anschluss des zweiten Transistors an dem Eingang oder dem Ausgang angeschlossen ist und der Source-Anschluss des ersten Transistors an den Drain-Anschluss des zweiten Transistors angeschlossen ist, weiterhin ist der Gate-Anschluss des ersten Transistors über einen ersten Widerstand mit einem ersten Pol einer Spannungsquelle und der Gate-Anschluss des zweiten Transistors über einen zweiten Widerstand mit einem zweiten Pol der Spannungsquelle verbunden. Bei dieser Lösung werden beispielsweise zwei komplementäre MOSFET-Transistoren in Reihe in eine Signalleitung des Einganges eingefügt. Die Transistoren werden über ihren jeweiligen Gate-Anschluss an eine entsprechend zu begrenzende Spannung gelegt. Vorteilhafter Weise wird der Gate-Anschluss des n-Kanal Transistors an die positiv zu begrenzende Spannung und der Gate-Anschluss des p-Kanal Transistors an die negativ zu begrenzende Spannung angelegt. Vorzugsweise ist für die zu begrenzende Spannung eine Gate-Source-Threshold-Spannung des jeweiligen Transistors zu beaufschlagen, um eine Begrenzung des eigentlichen Nutzsignals zu vermeiden.

In einer vorteilhaften Ausgestaltung weist die Schutzschaltung an dem Gate-Anschluss und dem Source-Anschluss des ersten Transistors eine Diode auf, welche parallel zu dem Gate-Anschluss und dem Source-Anschluss angeschlossen ist. Überschreitet beispielsweise eine negative Überspannung eine maximal zulässige Gate-Source-Spannung des n-Kanal Transistors, so wird die Gate-Source-Spannung beispielsweise mit einer Z-Diode begrenzt.

Insbesondere bei einem Einsatz von elektrischen Vorrichtungen oder elektrischen Schaltungsteilen eines Moduls in der Automatisierungstechnik ist es notwendig entsprechende Ein- oder Ausgänge von Automatisierungskomponenten vor Überspannungen zu schützen. Beispielsweise können in einem Industrieprozess durch mit Starkstrom angetriebene Motoren über Leistungsleitungen in Signalleitungen eingekoppelte Störungen, wie z.B. Überspannungen, auftreten. Damit diese eingekoppelten Störungen bzw. Überspannungen den Automatisierungskomponenten nicht schaden ist es von Vorteil, wenn eine Automatisierungskomponente mit einer elektrischen Vorrichtung zum Automatisieren industrieller Prozesse, welcher einen Ein- oder Ausgangskanal umfasst derart ausgestaltet ist, dass zum Schutz vor Überspannungen dem Ein- oder Ausgangskanal eine Schutzschaltung nach einem der Ansprüche 1 bis 3 vorgeschaltet ist.

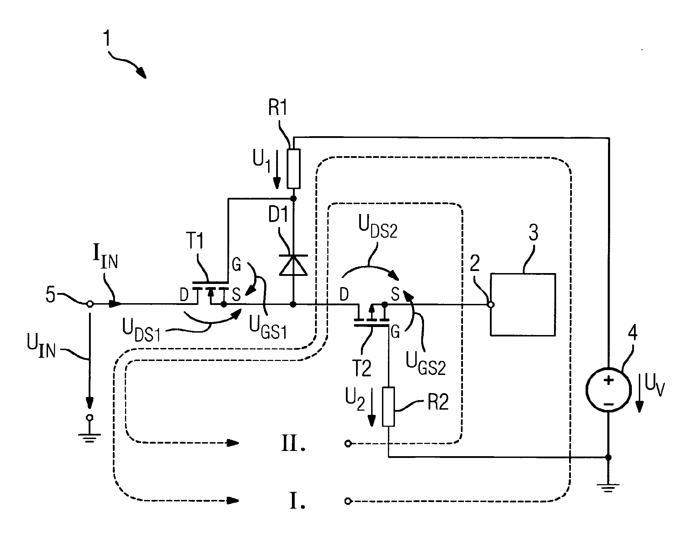

Die Zeichnung zeigt ein Ausführungsbeispiel, wobei mittels der Figur eine Eingangsschutzbeschaltung mit komplementären MOSFET-Transistoren dargestellt ist.

Gemäß der Figur ist eine Schutzschaltung 1 zum Schutz eines Einganges 2 einer elektrischen Vorrichtung 3 vor einer Überspannung wie folgt aufgebaut. An dem Eingang 2 ist eine Reihenschaltung angeordnet, die Reihenschaltung umfasst einen ersten Transistor T1 und einen zweiten Transistor T2, dabei ist der erste Transistor T1 als ein n-Kanal MOSFET und der zweite Transistor T2 als ein p-Kanal MOSFET ausgestaltet.

Jeder der beiden Transistoren T1,T2 weist einen Gate-Anschluss G, einen Drain-Anschluss D und einen Source-Anschluss S auf. Der Drain-Anschluss D des ersten Transistors T1 ist an einer ersten Anschlussstelle 5 und der Source-Anschluss S des zweiten Transistors T2 ist an dem Eingang 2 angeschlossen.

Die erste Anschlussstelle 5 dient in diesem Beispiel als verlängerter Eingang an dem Nutzsignale, beispielsweise aus einem industriellen Prozess von Sensoren, angelegt werden können. Zwischen der ersten Anschlussstelle 5 und dem Eingang 2 ist die eigentliche Schutzschaltung 1 angeordnet. Der Source-Anschluss S des ersten Transistors T1 ist an den Drain-Anschluss D des zweiten Transistors T2 angeschlossen. Der Gate-Anschluss G des ersten Transistors T1 ist über einen ersten Widerstand R1 mit einem ersten Pol + einer Spannungsquelle 4 und der Gate-Anschluss G des zweiten Transistors T2 ist über einen zweiten Widerstand R2 mit einem zweiten Pol - der Spannungsquelle 4 verbunden.

Über die erste Anschlussstelle 5 kann ein Eingangsstrom $I_{IN}$ über die Schutzschaltung 1 zu dem eigentlichen Eingang 2 der elektrischen Vorrichtung 3 fließen. Die Spannungsquelle 4 stellt eine Versorgungsspannung $U_v$ bereit.

An den Widerständen R1,R2 und den Transistoren T1,T2 sind folgende Spannungsabfälle eingetragen. An dem ersten Widerstand R1 fällt eine erste Spannung $U_1$ ab, An dem zweiten Widerstand R2 fällt eine zweite Spannung $U_2$ ab, über den Gate-Anschluss G und dem Source-Anschluss S des ersten Transistors T1 fällt eine Gate-Source-Spannung $U_{GS1}$ ab, über den Drain-Anschluss D und dem Source-Anschluss S des ersten Transistors T1 fällt eine Drain-Source-Spannung $U_{DS1}$ ab, über den Gate-Anschluss G und den Source-Anschluss S des zweiten Transistors T2 fällt eine Gate-Source-Spannung $U_{GS2}$ ab, über den Drain-Anschluss D und den Source-Anschluss S fällt eine Drain-Source-Spannung $U_{DS2}$ ab, als Eingangsspannung $U_{IN}$ liegt an der ersten Anschlussstelle 5 gegen Masse die Eingangsspannung $U_{IN}$ an.

Es ergibt sich eine erste Spannungsmasche I.

I. Masche

$$-U_V \ +U_1 \ +U_{GS1} \ -U_{DS1} \ +U_{IN} \ = \ 0$$

Bei einer Überspannung z.B. von +30V

$$\begin{aligned} U_{GS1} \ &= \ U_V \ -U_1 \ +U_{DS1} \ -U_{IN} \\ &= \ 5V \ -U_1 \ + \ U_{DS1} \ -30V \\ &= \ -U_1 \ +U_{DS1} \ -25V \end{aligned}$$

Es ergeben sich zwei Fälle der Begrenzung gegen Überspannungen:

1. Fall: Begrenzung gegen Überspannung

$$-U_V \ +U_1 \ +U_{GS1} \ -U_{DS1} \ +U_{IN} \ = \ 0,$$

die Gate-Source-Spannung $U_{GS1}$ wird jetzt mit der Abschnürspannung U-Threshold belegt, damit wird die Spannung $U_1$ zu Null und die Spannung $U_{DS1}$ ebenfalls zu Null, es verbleibt:

$U_{IN}$ -$U_V$-$U_{GS1-Threshold}$, welches eine maximale Eingangsspannung für einen Betrieb der Vorrichtung darstellt. Bei einer Spannung, welche über der maximalen Eingangsspannung liegt schnürt der n-Kanal Mosfet ab und begrenzt damit die Eingangsspannung und den Eingangsstrom.

2. Fall: Begrenzung gegen negative Überspannung

Mit einer zweiten Spannungsmasche II. ergibt sich:

$$-U_2 \ +U_{GS2} \ -U_{DS2} \ -UDS1 \ +U_{IN} \ = \ 0$$

Die Gate-Source-Spannung $U_{GS2}$ wird jetzt mit der Abschnürspannung U-Threshold belegt, damit wird die Spannung $U_2$ zu Null und die Spannungen $U_{DS2}$ = $U_{DS1}$ ebenfalls zu Null, es verbleibt: UIN = UGS2, welches eine maximale negative Eingangsspannung für einen Betrieb der Vorrichtung darstellt.

Bei einer Spannung unter dieser Spannung schnürt der p-Kanal MOSFET ab und begrenzt damit die Eingangsspannung und den Eingangsstrom.

Das zuvor genannte Prinzip funktioniert auch bei Tausch der beiden Transistoren.

$$U_{GS1} \ = \ -U_1 \ -25V$$

Die beiden Widerstände R1 und R2 sind jeweils als Gate-Vorwiderstände eingesetzt und stellen dementsprechend die zu begrenzenden Spannungen bereit.

Die Diode D1 ist nur notwendig, wenn die Eingangsspannung UIN so niedrig wird, dass die maximale Gate-Source-Spannung UGS1 des ersten Transistors überschritten wird, welches eine Zerstörung des ersten Transistors zur Folge hätte.

Mit der Schutzschaltung 1 ergeben sich folgende Vorteile: Im Gegensatz zum Stand der Technik (Schutzschaltung mit Clamping-Dioden) ist der in den Signalweg eingebrachte Serienwiderstand wesentlich kleiner als der Serienwiderstand der Schutzschaltung mit den Clamping-Dioden. In einem normalen Betriebszustand beläuft sich der Durchgangswiderstand der beiden Transistoren auf einen Wert, welcher in einem zweistelligen Ohmbereich liegt und kann darüber hinaus bei einer Auswahl der entsprechenden Transistoren weiter vermindert werden. Dies hat den Vorteil, dass bei Strom führenden Nutzsignalen, wie z.B. bei Konstantstromausgängen bei RTD-Baugruppen für Widerstandstemperaturdetektoren oder Stromein- und ausgaben, durch die hier vorgeschlagene Schutzmaßnahme kein wesentlicher Spannungsablauf an Bauteilen der Schutzschaltung entsteht. Darüber hinaus erzeugen die bei Spannungseingängen parasitär fließenden Ströme keinen erheblichen Spannungsabfall und wirken sich deshalb nicht auf ein Messsignal aus.

Ein weiterer Vorteil ist, dass eine eventuell auftretende Verlustleistung im Überspannungsfall an der Schutzschaltung sehr gering ist. Bei einem MOSFET werden bei Überspannungen durch ihren sehr hochohmigen Schaltzustand Stromflüsse durch die Schutzschaltung verhindert. Demnach tritt fast keine Verlustleistung innerhalb der Schutzschaltung auf und zudem ist die nachfolgende zu schützende Schaltung vor zu hohen Spannungen und Strömen geschützt.

Da die Gate-Anschlüsse G bei MOSFETs in der Regel sehr hochohmig angebunden sind, besteht keinerlei Verfälschung eines Nutzsignals im Betriebszustand, beispielsweise einer Automatisierungskomponente durch die Schutzschaltung 1.

Wird die Schutzschaltung 1 in einer Automatisierungskomponente eingesetzt so kann eine Zerstörung/Beschädigung/Vorschädigung einer in der Automatisierungskomponente angeordneten Modulelektronik vermieden werden. Vorgenannte Zerstörung/Beschädigung oder Vorschädigungen können infolge von Anlagenfehlern, beispielsweise fehlerhafter Verdrahtung, beispielsweise fehlerhaften Gebrauch, beispielsweise EMV-Einstrahlung, auftreten.

Die Schutzschaltung ist ebenfalls bei symmetrischen Versorgungsspannungen sowie bei Ein- und Ausgängen unabhängig von der Signalrichtung anwendbar.

**Patentansprüche**

1. Schutzschaltung (1) zum Schutz eines Eingangs (2) oder eines Ausgangs einer elektrischen Vorrichtung (3) vor einer Überspannung,
   wobei an dem Eingang (2) oder dem Ausgang eine Reihenschaltung angeordnet ist, wobei die Reihenschaltung einen ersten Transistor (T1) und einen zweiten Transistor (T2) umfasst, der erste Transistor (T1) ist als ein n-Kanal Feldeffekttransistor und der zweite Transistor (T2) ist als ein p-Kanal Feldeffekttransistor ausgestaltet, wobei jeder der Transistoren (T1,T2) einem Gate-Anschluss, einem Drain-Anschluss und einem Source-Anschluss aufweist, wobei der Drain-Anschluss des ersten Transistors (T1) an einer ersten Anschlussstelle (5) und der Source-Anschluss des zweiten Transistor s(T2) an dem Eingang (2) oder dem Ausgang angeschlossen ist und der Source-Anschluss des ersten Transistors (T1) an dem Drain-Anschluss des zweiten Transistor (T2) angeschlossen ist, **dadurch gekennzeichnet, daß** der Gate-Anschluss des ersten Transistors (T1) über einen ersten Widerstand (R1) mit einem ersten Pol (+) einer Spannungsquelle (4) und der Gate-Anschluss des zweiten Transistors (T2) über einen zweiten Widerstand (R2) mit einem zweiten Pol (4) der Spannungsquelle (4) verbunden ist.

2. Schutzschaltung (1) nach Anspruch 1, wobei an dem Gate-Anschluss und dem Source-Anschluss des ersten Transistors (T1) eine Diode (D1) angeschlossen ist.

3. Schutzschaltung (1) nach Anspruch 2, wobei die Diode (D1) als eine Z-Diode ausgestaltet ist und ihre Kathode am Gate-Anschluss des ersten Transistors (T1) angeschlossen ist.

4. Automatisierungskomponente mit einer elektrischen Vorrichtung (3) zum automatisieren industrieller Prozesse, welche einen Ein- oder Ausgangskanal umfasst,
   **dadurch gekennzeichnet, dass** zum Schutz vor Überspannungen dem Ein- oder Ausgangskanal eine Schutzschaltung (1) nach einem der Ansprüche 1 bis 3 vorgeschaltet ist.

**Claims**

1. Protective circuit (1) for protecting an input (2) or an output of an electrical apparatus (3) from an overvoltage, wherein
   a series circuit is arranged at the input (2) or the output, wherein the series circuit includes a first transistor (T1) and a second transistor (T2), the first transistor (T1) is embodied as an n-channel field effect transistor and the second transistor (T2) is embodied as a p-channel field effect transistor, wherein each of the transistors (Tl, T2) comprises a gate terminal, a drain terminal and a source terminal, wherein the drain terminal of the first transistor (T1) is connected to a first terminal point (5) and the source terminal of the second transistor (T2) is connected to the input (2) or the output and the source terminal of the first transistor (T1) is connected to the drain terminal of the second transistor (T2),
   **characterised in that**, the gate terminal of the first transistor (T1) is connected via a first resistor (R1) to a first pole (+) of a voltage source (4) and the gate terminal of the second transistor (T2) is connected via a second resistor (R2) to a second pole (4) of the voltage source (4).

2. Protective circuit (1) according to claim 1, wherein a diode (Dl) is connected to the gate terminal and the source terminal of the first transistor (T1).

3. Protective circuit (1) according to claim 2, wherein

the diode (DI) is embodied as a Z-diode and its cathode is connected to the gate terminal of the first transistor (T1).

4. Automation component having an electrical apparatus (3) for automating industrial processes, which includes an input or output channel, **characterised in that** a protective circuit (1) according to one of claims 1 to 3 is arranged upstream of the input or output channel in order to protect against overvoltages.

**Revendications**

1. Circuit ( 1 ) de protection pour la protection d'une entrée ( 2 ) ou d'une sortie d'un dispositif ( 3 ) électronique vis à vis d'une surtension, dans lequel il est monté à l'entrée ( 2 ) ou à la sortie un circuit série, le circuit série comprenant un premier transistor ( T1 ) et un deuxième transistor ( T2 ), le premier transistor ( T1 ) est conformé en transistor à effet de champ à canal n et le deuxième transistor ( T2 ) en transistor à effet de champ à canal p, chacun des transistors ( T1 , T2 ) ayant une borne de grille, un borne de drain et une borne de source, la borne de drain du premier transistor ( T1 ) étant reliée à un premier point ( 5 ) de connexion et la borne de source du deuxième transistor ( T2 ) à l'entrée ( 2 ) ou à la sortie et la borne de source du premier transistor ( T1 ) étant reliée à la borne de drain du deuxième transistor ( T2 ), **caractérisé en ce que** la borne de grille du premier transistor ( T1 ) est reliée par une première résistance ( R1 ) à un premier pôle ( + ) d'une source ( 4 ) de tension et la borne de grille du deuxième transistor ( T2 ) est reliée par une deuxième résistance ( R2 ) à un deuxième pôle ( 4 ) de la source ( 4 ) de tension.

2. Circuit ( 1 ) de protection suivant la revendication 1, dans lequel une diode ( D1 ) est reliée à la borne de grille et à la borne de source du premier transistor ( T1 ).

3. Circuit ( 1 ) de protection suivant la revendication 2, dans lequel la diode ( D1 ) est conformée en diode Z et sa cathode est reliée à la borne de grille du premier transistor ( T1 ).

4. Composant d'automatisation ayant un dispositif ( 3 ) électrique pour automatiser des processus industriels, qui comprend un canal d'entrée ou un canal de sortie, **caractérisé en ce que**, pour se protéger vis à vis de surtensions, un dispositif ( 1 ) de protection suivant l'une des revendications 1 à 3, est monté en amont du canal d'entrée ou de sortie.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9429961 A